## Europäisches Patentamt

(19) **European Patent Office**

**Office européen des brevets**

(11) Numéro de publication: **0 046 708**
**B1**

(12) **FASCICULE DE BREVET EUROPEEN**

(45) Date de publication du fascicule du brevet:
28.03.84

(51) Int. Cl.³: **G 06 F 15/336, H 03 H 17/02**

(21) Numéro de dépôt: **81401311.6**

(22) Date de dépôt: **17.08.81**

---

(54) Circuit de traitement numérique en arithmétique distribuée utilisant des multiplexeurs à l'entrée d'une mémoire.

---

(30) Priorité: **27.08.80 FR 8018580**

(43) Date de publication de la demande:
**03.03.82 Bulletin 82/9**

(45) Mention de la délivrance du brevet:
**28.03.84 Bulletin 84/13**

(84) Etats contractants désignés:
**DE GB NL SE**

(73) Titulaire: **Petit, Jean-Pierre, 16, Rue le Peletier,
F-22220 Treguier (FR)**
Titulaire: **Maitre, Xavier, Route de Pennker Le Bourg,
F-22300 Lannion (FR)**

(72) Inventeur: **Petit, Jean-Pierre, 16, Rue le Peletier,
F-22220 Treguier (FR)**
Inventeur: **Maitre, Xavier, Route de Pennker Le Bourg,
F-22300 Lannion (FR)**

(74) Mandataire: **Mongrédien, André et al, c/o
BREVATOME 25, rue de Ponthieu, F-75008 Paris (FR)**

(56) Documents cités:
US - A - 3 777 130

PHILIPS RESEARCH REPORTS, vol.30, no. 1, février
1975, EINDHOVEN (NL) T.A.C.M. CLAASEN et al.:
"Some Considerations on the Implementation of digital
systems for signal processing", pages 73-84
IEEE TRANSACTIONS ON CIRCUITS AND SYSTEMS,
vol. CAS-24, no. 12, décembre 1977, NEW YORK (US)
C.S. BURRUS: "Digital Filter Structures Described by
Distributed Arithmetic", pages 674-680
TELECOMMUNICATIONS & RADIO ENG., vol. 32/33, no.
9, septembre 1978, WASHINGTON (US) A.K.
GORSHKOV et al.: "The Realization of Digital Filters
without the Operation of Multiplication", pages 103-106
IEE PROCEEDINGS-E, vol. 128, no. 3, mai 1981, OLD
WOKING SURREY (GB) B.S. TAN et al.:

(56) Documents cités: (suite)
"Speed-optimized microprocessor implementation of a
digital filter", pages 85-93

---

ACTORUM AG

## Circuit de traitement numérique en arithmétique distribuée utilisant des multiplexeurs à l'entrée d'une mémoire

La présente invention a pour objet un circuit de traitement numérique en arithmétique distribuée. Elle trouve une application dans la réalisation de filtres numériques utilisables, notamment en télécommunications.

Le traitement numérique que réalise le circuit de l'invention est une somme pondérée pouvant s'exprimer par la relation:

$$v = \sum_{k=1}^{p} a_k u_k \qquad (1)$$

où $u_k$ désigne différents signaux numériques de rang k et où $a_k$ désigne des coefficients de pondération.

Comme cas particulier d'un tel traitement, on trouve le filtrage numérique récursif qui est classiquement caractérisé par une expression de la forme:

$$y_n = \sum_{k=0}^{p} a_k x_{n-k} - \sum_{k=1}^{q} b_k y_{n-k} \qquad (2)$$

où $x_{n-k}$ désigne des signaux d'entrée de rang n−k, $y_{n-k}$ des signaux de sortie de rang n−k réinjectés à l'entrée du filtre, $a_k$ des coefficients de la partie non récursive, dont l'ordre est p et $b_k$ des coefficients de la partie récursive, dont l'ordre est q; l'indice n prend toutes les valeurs, est un entier et caractérise le rang du signal de sortie.

Un filtre numérique récursif apte à effectuer un tel traitement comprend p+l entrées recevant les signaux $x_k$ et q entrées recevant les signaux $y_k$, soit au total p+q+l entrées; il comprend également une sortie délivrant la suite des signaux $y_n$.

La fonction de transfert H(z) d'un tel filtre, exprimée à l'aide de la variable complexe z, est:

$$H(z) = \frac{\sum_{k=0}^{p} a_k z^{-k}}{1 + \sum_{k=1}^{q} b_k z^{-k}} \qquad (3)$$

L'invention s'inscrit dans le cadre d'une technique particulière de traitement numérique dénommée arithmétique distribuée. Cette technique est décrite dans le brevet américain N° 3777130 délivré le 4 décembre 1973 à A. Croisier, D.J. Esteban, M.E. Levilion et V. Riso et intitulé «Digital Filter for PCM Encoded Signals», ainsi que dans l'article de A. Peled et B. Liu intitulé «A new Hardware Realization of Digital Filters» publié dans la revue «IEEE Trans. on ASSP», vol. ASSP 22, pp. 456-462, décembre 1974. En outre, l'article de C.S. Burrus intitulé «Digital Filter Structures Described by Distributed Arithmetic», publié dans la revue «IEEE Trans. on Circuits and Systems», vol. CAS-24, N° 12, pp. 674-680, décembre 1977, fournit une approche générale de cette question et décrit divers algorithmes et architectures utilisables. On pourra se reporter à ces documents pour tout détail concernant cette technique de l'arithmétique distribuée, celle-ci n'étant que brièvement rappelée ci-dessous afin que la compréhension de l'invention en soit facilitée.

Il s'agit d'effectuer une somme pondérée de signaux exprimée par la relation (1). On suppose que les $u_k$ sont codés sur r bits en code complément à 2, mais d'autres codes sont naturellement possibles. On note $u_k(0)$ le bit de signe et $u_k(j)$ les bits représentatifs de la valeur absolue de $u_k$, l'indice j étant compris entre 0 (exclu) et r−1 (inclus). On peut donc écrire:

$$u_k = -u_k(0)\, 2^0 + \sum_{j=1}^{r-1} u_k(j)\, 2^{-j} \qquad (4)$$

si $-1 \leq u_k < 1$.

Alors, après interversion des sommations, on peut écrire v sous la forme:

$$v = -2^0 \left( \sum_{k=1}^{p} u_k(0)\, a_k \right) + \sum_{j=1}^{r-1} 2^{-j} \left( \sum_{k=1}^{p} u_k(j)\, a_k \right) \quad (5)$$

Dans cette relation, le terme $u_k(j)$ qui figure dans l'expression entre parenthèses est le bit de rang j de $u_k$, et ce bit ne peut prendre que deux valeurs: 0 ou 1. Pour le premier produit $u_1(j)\, a_1$ il n'y a donc que deux valeurs possibles: 0 ou $a_1$. De même pour le produit $u_2(j)\, a_2$ qui ne peut prendre que les deux valeurs 0 et $a_2$; il n'y a donc que quatre valeurs possibles pour la somme de ces deux produits, à savoir 0, $a_1$, $a_2$, ou $a_1 + a_2$. De proche en proche, on voit qu'il y a finalement $2^p$ valeurs possibles pour la somme:

$$\sum_{k=1}^{p} u_k(j)\, a_k.$$

Cette somme, qui sera notée $w_j$ (puisqu'elle dépend du rang j considéré) prend donc l'une quelconque de $2^p$ valeurs déterminées uniquement par les coefficients $a_k$. Le calcul de la somme pondérée revient donc au calcul de l'expression:

$$v = -2^0 w_0 + \sum_{j=1}^{r-1} w_j\, 2^{-j}$$

où les $w_j$ peuvent être prédéterminés dès que l'on s'est fixé un jeu de coefficients $a_k$.

Celle de ces $2^p$ valeurs qui doit être retenue pour former $w_j$ est définie par l'ensemble des p bits de rang j des signaux d'entrée, à savoir $u_1(j)$, $u_2(j)$ ... $u_p(j)$.

Dans un circuit de traitement à arithmétique distribuée, les quantités $w_j$ sont inscrites dans une mémoire de $2^p$ mots de m bits, si m est le nombre de bits nécessaire pour exprimer ces sommes partielles. Le mot correspondant à un $w_j$ particulier est situé, dans cette mémoire, à l'adresse correspondant aux p bits de rang j des signaux d'entrée $u_k$.

Le nombre m est déterminé à partir des contraintes du problème à traiter et il peut être réduit de deux manières différentes: par troncation

des coefficients $a_k$ comme dans une réalisation traditionnelle, ou par troncation directe des quantités $w_j$ (mais alors le traitement n'est plus rigoureusement linéaire). Cette dernière méthode est décrite dans l'article de R. Lagadec et D. Pelloni intitulé «A Model for Distributed Arithmetic for Filters with Post-Quantized Lookup Table» publié dans «National Telecommunication Conference», 1977, pp. 29:3-1 à 29:3-6.

Si les signaux d'entrée $u_k$ sont introduits dans des registres-série, poids faible en tête, et si l'on dispose en sortie de la mémoire contenant les $w_j$ précalculés d'une unité arithmétique composée d'un additionneur-soustracteur, d'un registre-accumulateur à entrées parallèles et sorties parallèles pouvant être décalé, on peut réaliser la somme pondérée v en r opérations élémentaires telles que:
— lecture de la mémoire à l'adresse donnée par les p bits $u_k(j)$,
— addition du contenu du registre accumulateur parallèle-parallèle et du mot contenu dans la mémoire à l'adresse indiquée (pour $j = 0$, il faut soustraire le contenu de la mémoire au contenu du registre),
— décalage du registre-accumulateur parallèle-parallèle et des registres-série d'entrée (qui correspond à une division par deux du résultat intermédiaire).

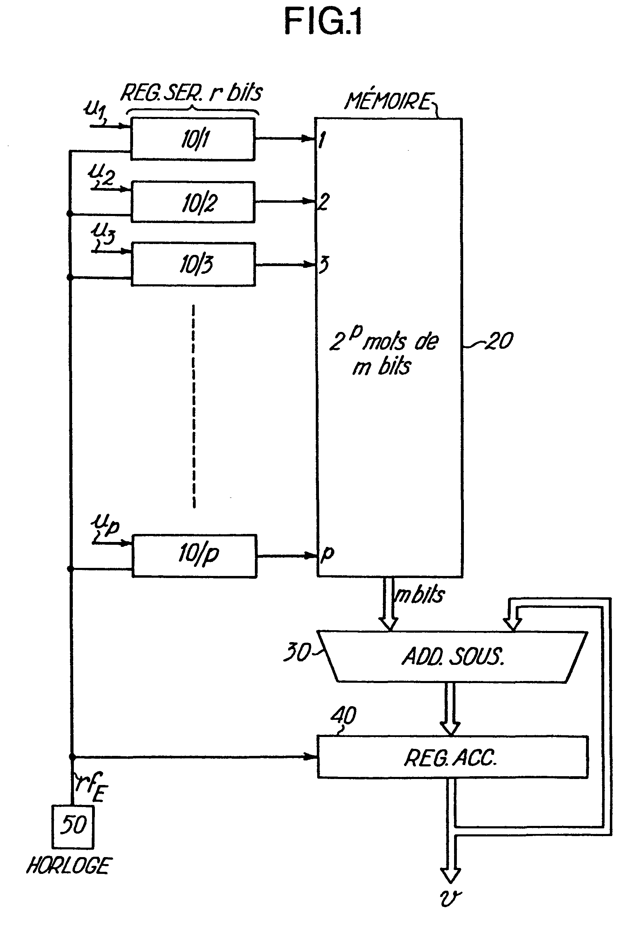

L'organisation matérielle d'un tel circuit est illustrée sur la fig. 1. Le circuit représenté comprend: p registres-série 10/1, 10/2, ..., 10/p de r bits recevant les p signaux d'entrée, une mémoire morte (20) de $p^p$ mots de m bits, un additionneur-soustracteur 30, un registre à entrées parallèles et sorties parallèles 40 décalable et un circuit d'horloge 50.

La mémoire possède p entrées reliées aux sorties des p registres d'entrée et elle contient les $2^p$ quantités suivantes:

$$\sum_{k=1}^{p} a_k \varepsilon_k$$

où $\varepsilon_k$ prend les valeurs 0 ou 1; l'adresse de chaque quantité est constituée par p bits appliqués aux p entrées.

Avec de tels moyens, on réalise en r coups d'horloge l'équivalent de p multiplications et $(p-1)$ additions, le déroulement des opérations étant le suivant:

Les quantités $u_k$ se présentent poids faible en tête dans les registres 10/1, ..., 10/p. La première quantité calculée est:

$$w_{r-1} = \sum_{k=1}^{p} u_k (r-1) a_k$$

puis, après décalage du registre 40, on calcule:

$2^{-1}w_{r-1}$, $w_{r-2}$, puis la somme $w_{r-2} + 2^{-1}w_{r-1}$,

puis, après un nouveau décalage, on calcule:

$2^{-1}(w_{r-2} + 2^{-1}w_{r-1}) = 2^{-1}w_{r-2} + 2^{-2}w_{r-1}$

et ainsi de suite jusqu'au $r^{ième}$ coup d'horloge, où l'on doit effectuer une soustraction correspondant aux bits de signe $u_k(0)$. Après ce dernier coup, les registres série 10/1, ..., 10/p doivent être décalés. On peut également tronquer ou arrondir le résultat v. Pour faire de la troncation, il suffit de ne pas prendre en compte les bits de faible poids, à partir d'un certain moment. Pour faire de l'arrondi, il faut ajouter, avant troncation des résultats, un demi-poids faible.

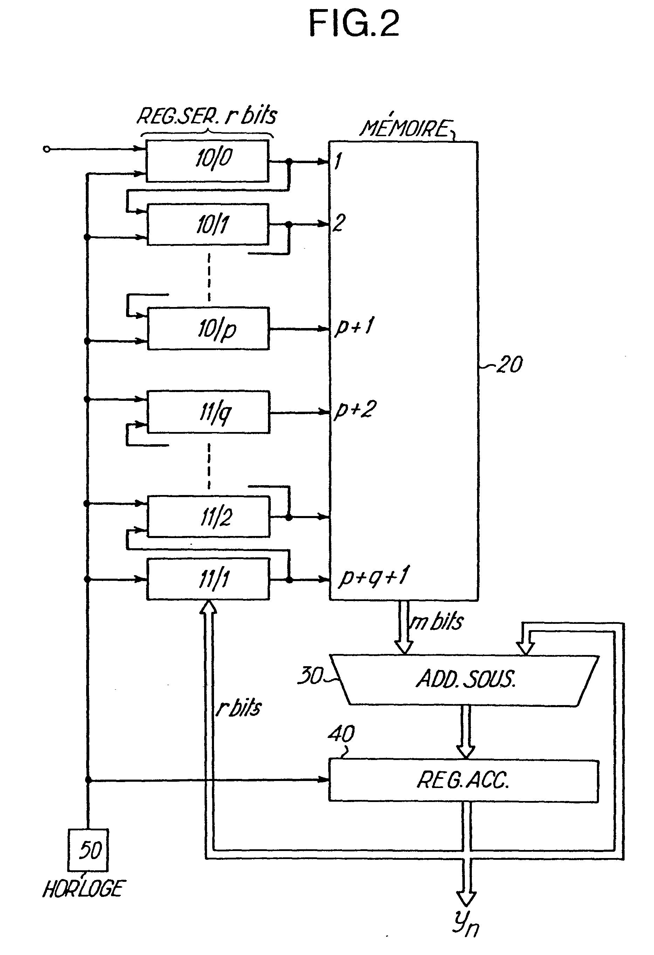

Ces principes peuvent être appliqués à la réalisation d'un filtre numérique récursif. L'opération à effectuer est alors celle de la relation (2) et le circuit correspondant est celui de la fig. 2. Il comprend une partie non récursive constituée de p+1 registres-série 10/0, 10/1, ..., 10/p recevant les signaux $x_n$, $x_{n-1}$, ..., $x_{n-p}$ et une partie récursive constituée de q registres 11/1, 11/2, ..., 11/q recevant les signaux $y_{n-1}$, $y_{n-2}$, ..., $y_{n-q}$, le registre 11/1 étant à chargement parallèle et les autres à chargement série; les registres 10/0 à 10/p−1 ont leur sortie reliée à l'entrée du registre suivant, de même que les registres 11/1 à 11/q−1. Le circuit comprend encore une mémoire 20 à p+q+1 entrées reliées à la sortie des registres, cette mémoire contenant $2^{p+q+1}$ mots de m bits, ces mots étant les quantités:

$$\sum_{j=0}^{p} a_j \varepsilon_{j+1} - \sum_{k=1}^{q} b_k \varepsilon_{p+q+2-k}$$

où les $\varepsilon_j$ sont égaux à 0 ou 1, j allant de 1 à p+q+1.

Le circuit comprend enfin les organes de traitement arithmétique déjà mentionnés, à savoir: un additionneur-soustracteur 30, un registre-accumulateur 40 à entrées parallèles et sorties parallèles, ainsi qu'une horloge 50 assurant le déroulement convenable des opérations (décalage des registres, chargement des registres parallèles, remise à zéro de l'accumulateur à la fin du cycle).

Par rapport au circuit de la fig. 1, on note donc deux modifications:
— le registre 11/1 correspondant à $y_{n-1}$ est à chargement parallèle; le contenu du registre parallèle-parallèle 40 doit être limité à r bits (par troncation ou arrondi), puis, à la fin de chaque cycle de calculs (r opérations élémentaires), chargé dans le registre $y_{n-1}$ de manière parallèle,
— les différents registres-série sont connectés les uns aux autres.

La fréquence de lecture de la mémoire et de décalage des registres est égale à $rf_E$ si $f_E$ est la fréquence d'échantillonnage du filtre numérique. Si les données $x_k$ entrent dans le dispositif sous forme série, poids faible en tête, à la bonne cadence et avec le bon nombre r de bits, le premier registre 10/0 n'est pas indispensable. S'il est maintenu, avec en quelque sorte un rôle de registre tampon, le résultat est retardé d'une période $1/f_E$. Dans certaines applications, les données se présentent sous forme parallèle: le premier registre doit alors être à chargement parallèle.

Dans un tel dispositif, la taille de la mémoire devient importante dès que les ordres p et q du filtre atteignent des valeurs de l'ordre de 6, ce qui correspond aux gabarits nécessaires à la transmission d'informations par impulsions codées (MIC).

Pour diminuer la taille de la mémoire, une solution consiste à utiliser un ou des multiplexeurs, au prix toutefois d'une augmentation de la fréquence de travail. M multiplexeurs peuvent être disposés à la sortie de la mémoire, comme il est décrit dans l'article de C.S. Burrus cité plus haut. Ces multiplexeurs possèdent M entrées et une sortie. Un tel multiplexeur sera symbolisé par la suite par la notation $M \rightarrow 1$. Il est commandé par un compteur modulo M à $\beta$ sorties qui reçoit des impulsions de l'horloge. La mémoire est alors composée de M mémoires différentes, chacune de $2^n$ mots de m bits, ces mémoires possédant n entrées d'adressage et une sortie. Le circuit comprend au total nM registres d'entrée répartis en n groupes chacun associé à une mémoire. La taille de l'ensemble de mémorisation est alors de $M \cdot 2^n$ mots de m bits, ce qui est inférieur à la taille de $2^{nM}$ que devrait présenter une seule mémoire sans multiplexeurs pour pouvoir traiter nM signaux d'entrée.

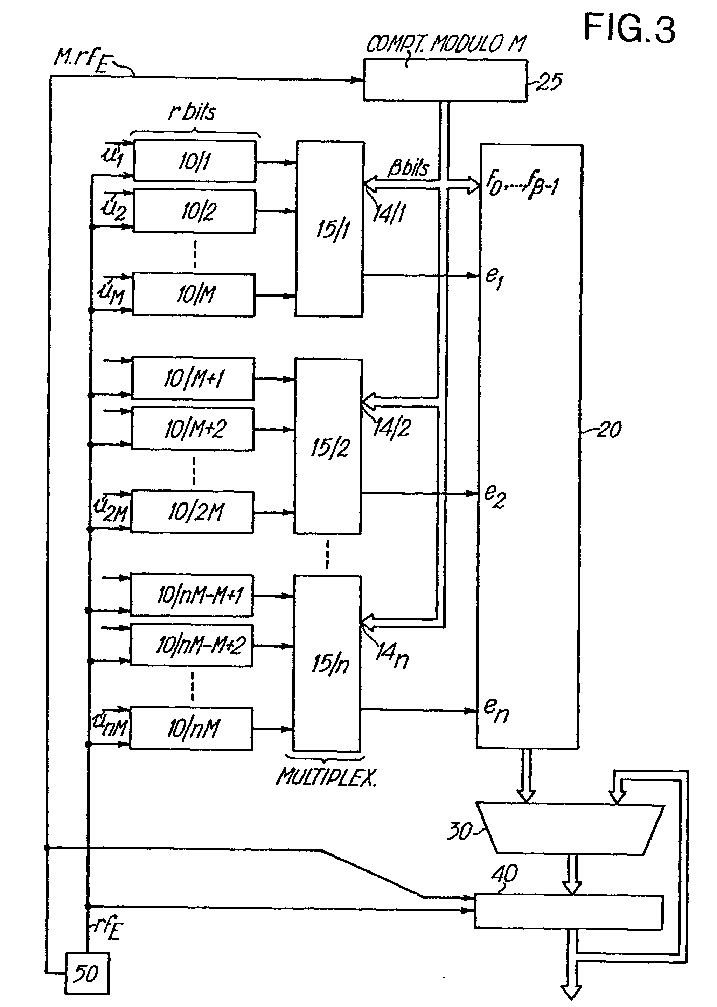

L'invention retient une disposition légèrement différente qui consiste à placer les multiplexeurs à l'entrée de la mémoire et non plus à la sortie. Cela permet d'utiliser une seule mémoire (au lieu de M) et n multiplexeurs $M \rightarrow 1$ au lieu de m. Le circuit correspondant est représenté sur la fig. 3. Il comprend encore nM registres d'entrée répartis en n groupes respectivement 10/1, 10/2, ..., 10/M pour le premier groupe, 10/M+1, 10/M+2, ..., 10/2M pour le second, etc., 10/nM−M+1, 10/nM−M+2, ..., 10/nM pour le dernier, un ensemble de n multiplexeurs $M \rightarrow 1$, respectivement 15/1, 15/2, ..., 15/n, chacun de ces multiplexeurs possédant M entrées reliées aux sorties des M registres du groupe correspondant et une sortie, une mémoire à $2^{\beta+n}$ mots de m bits. Cette mémoire est partitionnée en $2^\beta$ blocs de $2^n$ mots chacun. Cette mémoire possède d'une part $\beta$ entrées $(f_0, ..., f_{\beta-1})$ d'adressage d'un des blocs et d'autre part n entrées $e_1, e_2, ..., e_n$ d'adressage d'un mot à l'intérieur d'un bloc. Ces dernières entrées sont reliées aux sorties des n multiplexeurs. Quant aux premières, elles sont reliées aux $\beta$ sorties d'un compteur 25 modulo M, lesquelles sont également reliées à des entrées de sélection 14/1, 14/2, ..., 14/n des multiplexeurs. Le compteur reçoit des impulsions à la fréquence $M \cdot rf_E$ provenant de l'horloge 50. Le circuit comprend encore un additionneur-soustracteur 30 et un registre-accumulateur 40.

Par comparaison avec la fig. 1 (où l'on avait p = nM), on voit que la capacité de la mémoire est réduite de $2^{nM}$ à $2^{n+\beta}$, soit, puisque M est ici égal à $2^\beta$, une réduction de $2^{nM}$ à $M2^n$. Cette réduction s'effectue au détriment du nombre d'opérations qui passe de r à Mr.

Le fonctionnement de ce circuit est le suivant: .

La somme pondérée v est calculée en Mr opérations élémentaires telles que:

— lecture de la mémoire à l'adresse donnée par les n bits délivrés par les multiplexeurs dans le bloc sélectionné par le contenu du compteur,

— addition du mot lu dans la mémoire à cette adresse et du contenu du registre parallèle-parallèle (soustraction pour les bits de signe),

— incrémentation du contenu C du compteur d'une unité par une impulsion d'horloge,

— décalage des registres-série et du registre parallèle-parallèle uniquement lorsque le contenu C du compteur atteint M si l'on compte de 1 à M, ou M−1 si l'on compte de 0 à M−1.

Comme les quantités $u_k$ se présentent poids faible en tête, la première quantité calculée lorsque le contenu du compteur est C = 1 est:

$$w(r-1,1) = \sum_{\mu=0}^{n-1} a_{(1+\mu M)} u_{(1+\mu M)}(r-1)$$

puis, lorsque le contenu passe à 2:

$$w(r-1,2) + w(r-1,1)$$

et ainsi de suite jusqu'à:

$$\sum_{C=1}^{M} w(r-1,C)$$

où le contenu atteint M.

Un décalage des registres d'entrée et du registre sortie intervient alors. Le résultat intermédiaire est alors divisé par 2, soit:

$$2^{-1} \sum_{C=1}^{M} w(r-1,C)$$

auquel il vient s'ajouter $w(r-2,1)$, puis $w(r-2,2)$, etc.

L'organisation de la fig. 3 présente un inconvénient qui est le suivant. Elle suppose que le nombre M est une puissance exacte de 2 ($M = 2^\beta$). Si ce n'est pas le cas, la mémoire, dont la capacité est presque toujours une puissance de 2 en raison de ce que les constructeurs se bornent à fabriquer de telles mémoires, n'est pas complètement utilisée. Ainsi, avec M=3, le compteur possède $\beta=2$ sorties et la mémoire possède 4 blocs, l'un des quatre blocs n'étant jamais sélectionné par le compteur puisque celui-ci n'atteint jamais la valeur 4 (ou 3 si l'on compte de 0 à 2).

La présente invention a justement pour objet un circuit qui résout ce problème d'optimalisation d'utilisation de la mémoire.

L'idée sur laquelle se fonde l'invention est la suivante. On suppose que le contenu du compteur varie entre 0 et M−1 (un raisonnement analogue pourrait être tenu si ce contenu variait entre 1 et M). Les configurations binaires correspondant à M, M+1, ..., $2^\beta-1$ ne sont donc jamais délivrées par les $\beta$ sorties du compteur. Cela signifie que certaines configurations comprises entre 0 et M−1 seront entièrement caractérisées par un nombre de bits inférieur strictement à $\beta$. Autrement dit, parmi les $\beta$ bits délivrés par le compteur, il en est qui peuvent ne pas être significatifs, c'est-à-dire n'avoir aucune incidence sur la commande des multiplexeurs et de l'adressage de la mémoire.

Selon l'invention, on n'adresse pas ces bits non significatifs sur la mémoire de sorte qu'on libère des entrées supplémentaires qui peuvent alors être reliées à des registres-série supplémentaires. Tout se passe comme si on avait partitionné la mémoire en M blocs qui ne sont plus nécessairement de la même taille, tous les blocs étant maintenant utilisés, l'accroissement de taille des blocs les plus grands par rapport aux plus petits correspondant aux entrées supplémentaires libérées.

On montrera par la suite que, d'une façon générale, la mémoire peut être partitionnée en $[M-(2^\beta-M)]$ blocs de $2^n$ mots et en $(2^\beta-M)$ blocs de $2^{n+1}$ mots et que le nombre de registres supplémentaires peut atteindre $(2^\beta-M)$. Quant à la commutation de ces entrées de la mémoire libérée tantôt sur des registres-série supplémentaires, tantôt sur les sorties du compteur, elle s'effectue par un moyen de commutation approprié.

La définition précise de l'objet de l'invention est alors la suivante. Il s'agit d'un circuit de traitement numérique réalisant une somme pondérée de signaux numériques, comprenant n groupes de M registres-série dans lesquels les signaux à traiter sont introduits, n multiplexeurs à M entrées et une sortie, les M entrées de chaque multiplexeur étant reliées aux sorties des M registres-série d'un des groupes, une mémoire contenant des quantités précalculées caractéristiques de la somme pondérée à effectuer, cette mémoire ayant une capacité de $2^{\beta+n}$ mots répartie en différents blocs, un compteur modulo M à $\beta$ sorties, la mémoire possédant d'une part $\beta$ entrées d'adressage des différents blocs, reliées aux $\beta$ sorties du compteur et, d'autre part, n entrées d'adressage d'un mot à l'intérieur d'un bloc reliées aux sorties des n multiplexeurs, un additionneur-soustracteur relié à la mémoire, un registre-accumulateur relié à l'additionneur-soustracteur, et une horloge actionnant le compteur et les registres; ce circuit est caractérisé en ce que le nombre M étant inférieur à $2^\beta$, la mémoire est partitionnée en $[M-(2^\beta-M)]$ blocs de $2^n$ mots et en $(2^\beta-M)$ blocs de $2^{n+1}$ mots, ces blocs étant sélectionnés par les bits délivrés sur les sorties du compteur, et en ce qu'il comprend des registres-série supplémentaires en nombre au plus égal à $2^\beta-M$, ces registres-série recevant des signaux supplémentaires à traiter, et en ce qu'il comprend encore un moyen de multiplexage possédant des entrées qui sont reliées à ces registres supplémentaires ainsi qu'à celles des sorties du compteur qui peuvent délivrer des bits non significatifs à l'égard de l'adressage des blocs de la mémoire, ce moyen de multiplexage étant commandé par des sorties du compteur qui indiquent l'apparition de bits non significatifs, certaines des entrées d'adressage de blocs de la mémoire étant reliées aux sorties dudit moyen de multiplexage de telle manière qu'elles se trouvent reliées à travers ce moyen de multiplexage, soit aux registres supplémentaires lorsque des bits non significatifs apparaissent à la sortie du compteur, soit au compteur en l'absence de tels bits.

De préférence, le moyen de multiplexage est constitué par des multiplexeurs à deux entrées et une sortie.

Les caractéristiques de l'invention apparaîtront mieux après la description qui va suivre d'exemples de réalisation donnés à titre explicatif et nullement limitatif. Cette description se réfère à des dessins annexés qui font suite aux dessins déjà décrits et surlesquels:

la fig. 4 illustre un mode particulier de réalisation correspondant à M=3 et utilisant 7 registres-série (dont 1 supplémentaire);

la fig. 5 illustre un autre mode particulier de réalisation correspondant à M=5 et utilisant 13 registres-série (dont 3 supplémentaires).

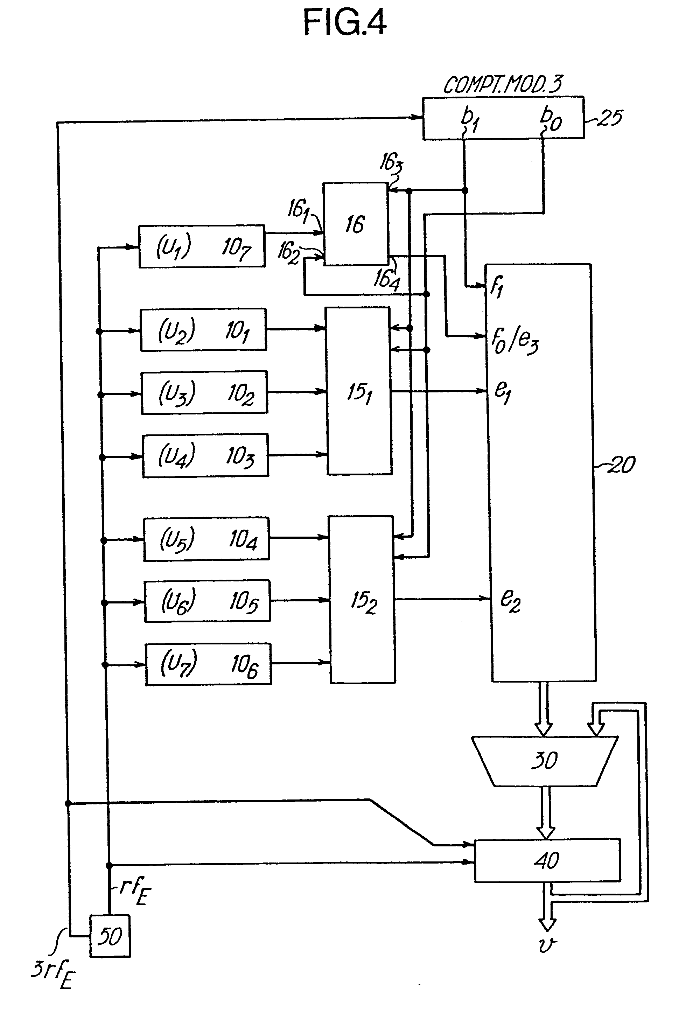

Le circuit représenté sur la fig. 4 comprend des éléments déjà représentés (de manière générale) sur la fig. 3, à savoir: 6 registres-série 10/1 à 10/6, 2 multiplexeurs 15/1 et 15/2 à trois entrées et une sortie (ce qui correspond donc à M=3), une mémoire 20 à 16 mots de m bits répartis en un bloc de 8 mots et deux blocs de 4 mots. Cette mémoire possède deux entrées d'adressage $e_1$ et $e_2$ reliées aux multiplexeurs 15/1 et 15/2 et deux entrées $f_0$ et $f_1$ (la première étant également désignée par $e_3$ pour des raisons qui apparaîtront par la suite) reliées aux deux sorties du compteur 25 modulo 3, un additionneur-soustracteur 30, un registre-accumulateur 40 et enfin une horloge 50.

Le circuit comprend en outre, et selon une caractéristique de l'invention, un septième registre-série 10/7 qui reçoit un septième signal à traiter, un multiplexeur 16 à deux entrées de signal 16/1 et 16/2, une entrée de commande 16/3 et une sortie 16/4 reliée à l'entrée $f_0$ de la mémoire. Le compteur délivre sur ses deux sorties deux bits $b_0$ (de poids faible) et $b_1$ (de poids fort). Le bit $b_1$ est appliqué à l'entrée de commande 16/3 du multiplexeur 16 et à l'entrée $f_1$ de la mémoire. Le bit $b_0$ est appliqué à l'entrée 16/2 du multiplexeur 16. Par ailleurs, les bits $b_0$ et $b_1$ sont appliqués aux multiplexeurs 15/1 et 15/2 qu'ils commandent.

Avec les notations précédentes, le circuit de la fig. 4 illustre donc le cas où M=3, $\beta=2$, n=2. Son fonctionnement est alors le suivant. Le compteur 25 compte de 0 à 2. Les configurations binaires délivrées par ses sorties sont donc les suivantes:

| $b_1$ | $b_0$ |
|---|---|
| 0 | 0 |
| 0 | 1 |
| 1 | $\boxed{0}$ |

La configuration binaire 11 n'est jamais produite puisque le contenu du compteur n'atteint pas 3. Il en résulte que, si $b_1$ est à 1, le bit de poids faible $b_0$ n'est pas significatif puisqu'à lui seul $b_1=1$ suffit pour adresser un des blocs de la mémoire et pour commander les multiplexeurs 15/1 et 15/2, le bit $b_0$ n'intervenant pas dans cet adressage et cette commande. On peut donc libérer une entrée supplémentaire de mémoire lorsque $b_1=1$ et affecter cette entrée à un registre d'entrée, ce qui permet de constituer un bloc mémoire de taille double. Cette commutation est obtenue par le multiplexeur 16. La sortie 16/4 de cet organe est reliée à l'entrée 16/1 lorsque le bit $b_1$ appliqué sur 16/3 est à 1. Elle est reliée à 16/2 lorsque ce bit est à 0. Par ailleurs, la sortie du multiplexeur 16 est réunie à l'entrée $f_0/e_3$ de la mémoire. Cette entrée est donc reliée soit au septième registre 10/7

lorsque $b_1 = 1$, soit au compteur 25 lorsque $b_1 = 0$, ce qui explique sa double notation. En même temps, le bit $b_1 = 1$ appliqué à l'entrée $f_1$ sélectionne le bloc de 8 mots de la mémoire, un mot de ce bloc étant adressé par les trois bits appliqués en $e_1$, $e_2$ et $e_3$. Lorsque $b_1$ est à 0, le bit $b_0$ est appliqué à l'entrée $f_0$ de la mémoire à travers le multiplexeur 16 et il sélectionne l'un ou l'autre (selon qu'il est à 0 ou à 1) des deux blocs mémoire de 4 mots et ces blocs mémoire travaillent chacun avec les deux entrées $e_1$ et $e_2$. Les 16 mots de la mémoire sont donc bien tous utilisés.

Il apparaît, sur cet exemple, que le bit $b_0$ n'a une signification, en ce qui concerne la sélection d'un bloc mémoire, que lorsque le bit $b_1$ n'est pas à 1. Dans le cas contraire, le bit $b_0$ ne participe pas à la sélection d'un bloc mémoire, ce rôle étant exclusivement dévolu au bit $b_1$. C'est en ce sens qu'on peut dire que ce bit est quelquefois non significatif.

Dans l'exemple de la fig. 4, la mémoire de $2^4$ mots est partitionnée en un bloc de $2^3$ mots et en deux blocs de $2^2$ mots, c'est-à-dire, en reprenant la notation n déjà utilisée (avec $n=2$), en un bloc de $2^{n+1}$ mots et en deux blocs de $2^n$ mots.

On peut montrer que cette manière d'organiser la mémoire est générale. En effet, une mémoire de $2^{\beta+n}$ mots peut être partitionnée en mémoires de $2^n$ mots et en mémoires de $2^{n+1}$ mots, ce qui résulte de l'égalité:

$$2^{\beta+n} = [M - (2^\beta - M)]\, 2^n + (2^\beta - M)2^{n+1}$$

de démonstration immédiate. Dans cette égalité, le terme entre crochets vérifie les inégalités:

$$0 < M - (2^\beta - M) \leqslant 2^\beta$$

et le terme entre parenthèses l'inégalité $2^\beta - M \geqslant 0$, car $2^{\beta-1} < M \leqslant 2^\beta$. Cela signifie que la mémoire de $2^{\beta+n}$ mots peut être partitionnée en $M - (2^\beta - M)$ blocs de taille $2^n$ et en $(2^\beta - M)$ blocs de taille $2^{n+1}$.

D'une manière générale, et conformément à l'invention, on peut donc libérer $(2^\beta - M)$ entrées supplémentaires, ce qui porte le nombre possible d'entrées p à:

$$p_{max} = nM + 2^\beta - M \qquad (12)$$

pour $2^{\beta-1} < M \leqslant 2^\beta$.

Si M est égal à la puissance $\beta$ de 2, le nombre d'entrées supplémentaires tombe à zéro puisque l'on retrouve le cas de la fig. 3. Le tableau suivant illustre différents cas pour toutes les valeurs de M comprises entre 2 et 8.

| M | $\beta$ | $p_{max.}$ | Capacité mémoire | Nombre de coups d'horloge |
|---|---|---|---|---|
| 2 | 1 | $2n$ | $2^{n+1}$ | $2r$ |
| 3 | 2 | $3n+1$ | $2^{n+2}$ | $3r$ |
| 4 | 2 | $4n$ | $2^{n+2}$ | $4r$ |
| 5 | 3 | $5n+3$ | $2^{n+3}$ | $5r$ |
| 6 | 3 | $6n+2$ | $2^{n+3}$ | $6r$ |
| 7 | 3 | $7n+1$ | $2^{n+3}$ | $7r$ |
| 8 | 3 | $8n$ | $2^{n+3}$ | $8r$ |

Ce tableau montre qu'en fonction du nombre d'entrées p et pour une taille de mémoire donnée, plusieurs solutions sont possibles; celle qui conduit au nombre de coups d'horloge le plus faible sera choisie en pratique.

*Exemples:*

  1) $p=4$ peut être obtenu avec:
M=2 et n=2
M=3 et n=1
M=4 et n=1

pour une capacité mémoire de 8 mots de m bits. Le nombre de coups d'horloge minimal est obtenu avec la première solution.

  2) $p=7$ peut être obtenu avec:
M=3 et n=2
M=4 et n=2
M=5 et n=1
M=6 et n=1
M=7 et n=1
M=8 et n=1

pour une capacité mémoire de 16 mots de m bits. Le nombre de coups d'horloge minimal est obtenu avec la première solution.

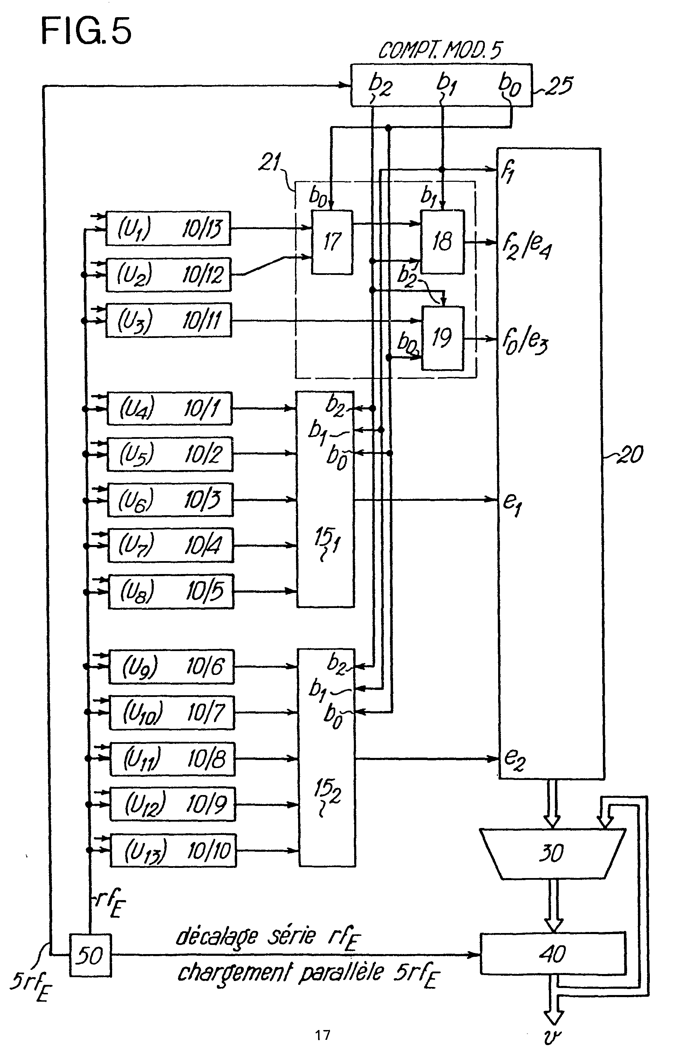

La fig. 5 représente un autre exemple de réalisation correspondant au cas suivant: $p=13$, $M=5$, $\beta=3$, $2^\beta=8$ et $n=2$.

Par rapport au cas précédemment illustré, on note les différences suivantes: tout d'abord les multiplexeurs 15/1, et 15/2 sont à 5 entrées au lieu de 3, le compteur 25 est modulo 5 au lieu de 3 et il possède 3 sorties au lieu de 2, lesquelles délivrent 3 bits $b_0$, $b_1$ et $b_2$, et il existe 3 registres supplémentaires 10/11, 10/12 et 10/13; par ailleurs, le moyen de multiplexage 21 est maintenant constitué par 3 multiplexeurs $2 \rightarrow 1$, respectivement 17, 18 et 19, commandés respectivement par les bits $b_0$, $b_1$ et $b_2$. Les deux multiplexeurs 17 et 18 réalisent deux étages de multiplexage, ce qui permet d'adresser sur l'entrée $f_2/e_4$ de la mémoire soit le bit $b_2$, soit l'une quelconque des sorties des registres supplémentaires 10/12 et 10/13.

Le fonctionnement de ce circuit est le suivant. Le compteur voit son contenu passer de 0 à 4 et il délivre les configurations binaires suivantes:

| $b_2$ | $b_1$ | $b_0$ |
|---|---|---|
| 0 | 0 | 0 |
| 0 | 0 | 1 |
| [0] | 1 | 0 |
| [0] | 1 | 1 |
| 1 | [0] | [0] |

Quand le bit $b_2$ est à 1, les bits $b_1$ et $b_0$ ne sont pas significatifs. Quand le bit $b_1$ est à 1, le bit $b_2$ n'est pas significatif, et cela deux fois de suite. Il semblerait alors qu'on puisse libérer 4 entrées supplémentaires au lieu des 3 envisagées précédemment. En fait, on ne peut pas indépendamment utiliser toutes ces entrées supplémentaires. Ce point apparaît lorsqu'on partitionne la mémoire en 5 blocs:

1er bloc: taille 4 mots; correspond à l'adresse
2e bloc: taille 4 mots; correspond à l'adresse 001
3e bloc: taille 8 mots; correspond aux adresses 010 et 110

4e bloc: taille 8 mots; correspond aux adresses 011 et 111

5e bloc: taille 8 mots; correspond aux adresses 100 et 101

Les adresses 110 et 111 sont déjà utilisées dans les 3e et 4e blocs et ne peuvent pas être réutilisées dans le 5e bloc.

La taille totale de la mémoire est bien de 32 mots, soit $2^{\beta+n}=2^5$.

Naturellement, dans un circuit tel que celui de la fig. 5, d'autres dispositifs de multiplexage que les 3 multiplexeurs $2 \rightarrow 1$ pourraient être utilisés pour obtenir le même résultat, par exemple deux multiplexeurs $2 \rightarrow 1$ disposés chacun à la sortie d'un des registres 10/12 ou 10/13, ou un multiplexeur à 3 entrées reliées à 10/12, 10/13 et $b_2$, etc. D'une manière générale, et comme il a été indiqué dans la définition de l'invention donnée plus haut, il convient d'utiliser un moyen de multiplexage apte à relier les entrées libérées de la mémoire soit aux registres supplémentaires lorsque des bits non significatifs apparaissent à la sortie du compteur, soit au compteur en l'absence de tels bits.

A partir des deux exemples décrits correspondant à M=3 et M=5, on peut aisément poursuivre le raisonnement:

— Pour M=6, le contenu du compteur va passer de 0 à 5 et le compteur va délivrer les configurations:

| $b_2$ | $b_1$ | $b_0$ |
|---|---|---|
| 0 | 0 | 0 |
| 0 | 0 | 1 |
| [0] | 1 | 0 |
| [0] | 1 | 1 |
| 1 | 0 | 0 |
| 1 | 0 | 1 |

où les bits non significatifs sont encadrés, et l'on peut libérer 2 entrées supplémentaires correspondant à ces bits.

— Pour M=7, le contenu du compteur va passer de 0 à 6 et le compteur va délivrer les configurations:

| $b_2$ | $b_1$ | $b_0$ |
|---|---|---|
| 0 | 0 | 0 |
| 0 | 0 | 1 |
| 0 | 1 | 0 |
| [0] | 1 | 1 |
| 1 | 0 | 0 |
| 1 | 0 | 1 |
| 1 | 1 | 0 |

et on peut libérer 1 entrée supplémentaire correspondant au seul bit non significatif encadré.

La description qui précède se rapporte à un circuit réalisant une somme pondérée. L'application à la réalisation d'un filtre récursif est immédiate, comme les fig. 1 et 2 l'ont montré. Il suffit pour cela de relier les registres-série en cascade avec un chargement parallèle du premier registre de la partie récursive (11/1 de la fig. 2).

Ce filtre peut d'ailleurs être du type à suréchantillonnage, comme décrit dans la demande de brevet français No EN 80.18579 déposée par les mêmes demandeurs et intitulée « Filtre récursif de suréchantillonnage en arithmétique distribuée ».

## Revendications

1. Circuit de traitement numérique réalisant une somme pondérée de signaux numériques, comprenant n groupes de M registres-série (10/1, ..., 10/nM (fig. 3) dans lesquels les signaux à traiter sont introduits, n multiplexeurs (15/1, 15/2, ..., 15/n, fig. 3) à M entrées et une sortie, les M entrées de chaque multiplexeur étant reliées aux sorties des M registres-série d'un des groupes, une mémoire (20, fig. 3) contenant des quantités précalculées caractéristiques de la somme pondérée à effectuer, cette mémoire ayant une capacité de $2^{\beta+n}$ mots répartie en différents blocs, un compteur (25, fig. 3) modulo M à $\beta$ sorties, la mémoire (20) possédant d'une part $\beta$ entrées d'adressage des différents blocs ($f_0$, $f_1$, ...) reliées aux $\beta$ sorties du compteur et, d'autre part, n entrées d'adressage d'un mot à l'intérieur d'un bloc ($e_1$, $e_2$, ...) reliées aux sorties des n multiplexeurs, un additionneur-soustracteur (30, fig. 3) relié à la mémoire, un registre-accumulateur (40, fig. 3) relié à l'additionneur-soustracteur, et une horloge (50, fig. 3) actionnant le compteur et les registres, ce circuit étant caractérisé en ce que le nombre M étant inférieur à $2^{\beta}$, la mémoire est partitionnée en $[M-(2^{\beta}-M)]$ blocs de $2^n$ mots et en $(2^{\beta}-M)$ blocs de $2^{n+1}$ mots, ces blocs étant sélectionnés par les bits délivrés sur les sorties du compteur, et en ce qu'il comprend des registres-série supplémentaires en nombre au plus égal à $2^{\beta}-M$, ces registres-série recevant des signaux supplémentaires à traiter, et en ce qu'il comprend encore un moyen de multiplexage (16, fig. 4, 21, fig. 5) possédant des entrées qui sont reliées à ces registres supplémentaires ainsi qu'à celles des sorties du compteur qui peuvent délivrer des bits non significatifs à l'égard de l'adressage des blocs de mémoire, ce moyen de multiplexage étant commandé par des sorties du compteur qui indiquent l'apparition de bits non significatifs, certaines des entrées d'adressage de blocs de la mémoire étant reliées aux sorties dudit moyen de multiplexage de telle manière qu'elles se trouvent reliées à travers ce moyen de multiplexage, soit aux registres supplémentaires lorsque des bits non significatifs apparaissent à la sortie du compteur, soit au compteur en l'absence de tels bits.

2. Circuit selon la revendication 1, caractérisé en ce que le moyen de multiplexage est constitué par au moins un multiplexeur (16, fig. 4, 17, 18, 19, fig. 5) à deux entrées et une sortie.

3. Circuit selon la revendication 1, caractérisé en ce que la somme pondérée effectuée correspond à un filtrage récursif, les registres-série de la partie non récursive d'une part, et de la partie récursive d'autre part étant alors reliés les uns aux autres en cascade, le premier registre de la partie récursive (11/1, fig. 2) étant à chargement parallèle à partir du registre-accumulateur (40, fig. 2).

**Patentansprüche**

1. Schaltkreis zum numerischen Verarbeiten, mit dem eine gewichtete Summe von numerischen Signalen erzeugbar ist, mit n Gruppen von M Reihenregistern (10/1, ..., 10/nM, Fig. 3), in die die zu verarbeitenden Signale eingegeben werden, n Multiplexern (15/1, 15/2, ..., 15/n, Fig. 3) mit M Eingängen und einem Ausgang, wobei die M Eingänge eines jeden Multiplexers mit den Ausgängen der M Reihenregister einer der Gruppen verbunden sind, einem Speicher (20, Fig. 3) der vorausberechnete, für die zu bildende gewichtete Summe charakteristische Werte enthält und ein Fassungsvermögen von $2^{\beta+n}$ Worten aufweist, die auf verschiedene Blöcke verteilt sind, einem Zähler (25, Fig. 3) Modulo M mit $\beta$ Ausgängen, wobei der Speicher (20) einerseits $\beta$ Adressierungseingänge für die verschiedenen Blöcke ($f_0$, $f_1$, ...), die mit den $\beta$ Ausgängen des Zählers verbunden sind, und andererseits n Adressierungseingänge für ein Wort in einem Block ($e_1$, $e_2$, ...) aufweist, die mit den Ausgängen der n-Multiplexer verbunden sind, einer mit dem Speicher verbundenen Additions-Substraktions-Einrichtung (30, Fig. 3), einem Speicherregister (40, Fig. 3), welches mit der Additions-Substraktions-Einrichtung verbunden ist, und einem Taktimpulsgeber (50, Fig. 3), der den Zähler und die Register betätigt, dadurch gekennzeichnet, dass die Zahl M kleiner als $2^\beta$ ist, der Speicher in $[M-(2^\beta-M)]$ Blöcke mit $2^n$ Worten und in $(2^\beta-M)$ Blöcke mit $2^{n+1}$ Worten unterteilt ist, wobei diese Blöcke durch die an die Ausgänge des Zählers gelieferten Bits ausgewählt werden, und dass zusätzliche Reihenregister mit einer Zahl von höchstens gleich $2^\beta-M$ vorgesehen sind, die zusätzliche, zu verarbeitende Signale erhalten, dass ferner eine Multiplexereinrichtung (16, Fig. 4; 21, Fig. 5) vorgesehen ist, die Eingänge aufweist, welche Eingänge aufweist, die mit diesen zusätzlichen Registern verbunden sind sowie mit denjenigen Ausgängen des Zählers, die in Bezug auf die Adressierung der Blöcke des Speichers nicht geltende Bits abgeben können, wobei die Multiplexereinrichtung von den Ausgängen des Zählers gesteuert wird, welche das Auftreten von nicht geltenden Bits anzeigen, und dass gewisse Adressierungseingänge der Blöcke des Speichers mit den Ausgängen der Multiplexereinrichtung derart verbunden ist, dass sie über diese Multiplexereinrichtung entweder mit den zusätzlichen Registern, wenn die nicht geltenden Bits am Ausgang des Zählers auftreten, oder beim Fehlen solcher Bits mit dem Zähler verbunden sind.

2. Schaltkreis nach Anspruch 1, dadurch gekennzeichnet, dass die Multiplexereinrichtung von wenigstens einem Multiplexer (16, Fig. 4; 17, 18, 19, Fig. 5) gebildet ist, welcher zwei Eingänge und einen Ausgang aufweist.

3. Schaltkreis nach Anspruch 1, dadurch gekennzeichnet, dass die erzeugte, gewichtete Summe einem rekursiven Filtern entspricht und dass die Reihenregister des nichtrekursiven Teils einerseits und des rekursiven Teils andererseits kaskadenförmig miteinander verbunden sind, wobei das erste Register des rekursiven Teils (11/1, Fig. 2) von dem Speicherregister (40, Fig. 2) aus parallel geladen werden kann.

**Claims**

1. Digital processing circuit producing a weighted sum of digital signals, comprising n groups of M series-registers (10/1, ..., 10nM, Fig. 3) into which the signals to be processed are introduced, n multiplexers (15/1, 15/2, ..., 15/n, Fig. 3) having M inputs and one output, the M inputs of each multiplexer being connected to the outputs of the M series-registers of one of the groups, a memory (20, Fig. 3) containing precalculated quantities characteristic of the weighted sum to be produced, said memory having a capacity of $2^{\beta+n}$ words distributed in different blocks, a counter (25, Fig. 3) modulo M having $\beta$ outputs, the memory (20) having on the one hand $\beta$ inputs for addressing different blocks ($f_0$, $f_1$, ...) connected to $\beta$ outputs of the counter and, on the other hand, n inputs for addressing a word within a block ($e_1$, $e_2$, ...) connected to the outputs of the n multiplexers, an adder-subtractor (30, Fig. 3) connected to the memory, a register-accumulator (40, Fig. 3) connected to the adder-subtractor, and a timer (50, Fig. 3) actuating the counter and the registers, said circuit being characterized in that the number M is less than $2^\beta$, the memory is partitioned into $[M-(2^\beta-M)]$ blocks of $2^n$ words and $(2^\beta-M)$ blocks of $2^{n+1}$ words, said blocks being selected by the bits delivered to the outputs of the counter, and in that it comprises a number of supplementary series-registers at most equal to $2^\beta-M$, said series-registers receiving supplementary signals for processing, and in that it also comprises a multiplexing means (16, Fig. 4, 21, Fig. 5) having inputs connected to the supplementary registers as well as those connected to the outputs of the counter which can deliver bits that are non-significant with respect to the addressing of blocks of the memory, said multiplexing means being commanded by outputs of the counter indicating the appearance of non-significant bits, certain of the inputs for addressing blocks of the memory being connected to outputs of the multiplexing means whereby they may be connected through the multiplexing means, either to the supplementary registers when non-significant bits appear at the output of the counter, or to the counter in the absence of such bits.

2. Circuit according to claim 1, characterized in that the multiplexing means comprises at least one multiplexer (16, Fig. 4; 17, 18, 19, Fig. 5) having two inputs and one output.

3. Circuit according to claim 1, characterized in that the weighted sum produced corresponds to a recursive filtering, the series-registers of the non-recursive part, on the one hand, and of the recursive part, on the other hand, being thereby connected in cascade to one another, the first register of the recursive part (11/1, Fig. 2) being loadable in parallel to the register-accumulator (40, Fig. 2).

# FIG.1

REG.SER. $r$ bits

$u_1$   10/1

$u_2$   10/2

$u_3$   10/3

$u_p$   10/p

MÉMOIRE

1

2

3

$2^p$ mots de m bits   20

$p$

$m$ bits

30   ADD. SOUS.

40   REG. ACC.

$rf_E$

50

HORLOGE

$v$

# FIG.2

REG.SER. r bits

MÉMOIRE

10/0 → 1

10/1 → 2

10/p → p+1

11/q → p+2

11/2

11/1 → p+q+1

~20

m bits

30 — ADD. SOUS.

r bits

40 — REG. ACC.

50

HORLOGE

$y_n$

FIG.3

# FIG.4

# FIG.5